# EUROPEAN PATENT APPLICATION

(11) **EP 3 115 148 A1**
(43) Date of publication of application: **11.01.2017**
(21) Application number: 15759068.8
(22) Date of filing: 02.03.2015
(51) Int. Cl.: B23Q 1/01, B23Q 1/60, B23Q 1/66, G12B 5/00, H01L 21/027, H01L 21/68

(54) **TABLE APPARATUS, MEASURING APPARATUS, MACHINE TOOL, AND SEMICONDUCTOR MANUFACTURING APPARATUS**

(30) Priority: 03.03.2014 JP 2014040717
(71) Applicant: NSK Ltd., Tokyo 141-8560 (JP)
(72) Inventor: FUJITA, Daisuke, Fujisawa-shi Kanagawa 251-8501 (JP)
(74) Representative: Schwabe - Sandmair - Marx
(86) International application number: PCT/JP2015/056088
(87) International publication number: WO 2015/133436

(57) **Abstract**

A table device (100) includes: a first table (1) that includes a first upper surface; a second table (2) that is arranged on one side of the first table in a first axial direction parallel to a first axis in a predetermined plane and includes a second upper surface; a first guiding device (3) that guides the first table in the first axial direction; and a second guiding device (4) that guides the second table in the first axial direction. The first and second guiding devices are arranged in a second axial direction parallel to a second axis in the predetermined plane, the second axis being perpendicular to the first axis.

## Description

### Field

The present invention relates to a table device, measuring device, machine tool, and semiconductor manufacturing device.

### Background

In a measuring device and a machine tool, a table device with a movable table is used. A technique related to a positioning table with a first and second tables is disclosed in Patent Literature 1.

### Citation List

### Patent Literature

Patent Literature 1: Japanese Patent Application Laid-open Publication No. 63-300837

### Summary

### Technical problem

In a table device, limited movable ranges of first and second tables may cause the first and second tables not to be arranged in desired relative positions, and degrade performances of a measuring device and a machine tool including the table device. For example, the limited movable ranges of the first and second tables may not allow the first and second tables to come close to each other. As a result, objects placed on the first and second tables may not be moved smoothly.

An object of the present invention is to provide a table device that can smoothly move the first and second tables to target positions. Another object of the present invention is to provide a measuring device and a machine tool that can suppress degradation in performances.

### Solution to Problem

A first aspect of the present invention provides a table device that includes: a first table that includes a first upper surface; a second table that is arranged on one side of the first table in a first axial direction parallel to a first axis in a predetermined plane and includes a second upper surface; a first guiding device that guides the first table in the first axial direction; and a second guiding device that guides the second table in the first axial direction, wherein the first and second guiding devices are arranged in a second axial direction parallel to a second axis in the predetermined plane, the second axis being perpendicular to the first axis.

According to the first aspect of the present invention, the first guiding device that guides the first table in the first axial direction and the second guiding device that guides the second table in the first axial direction are arranged in the second axial direction. Therefore, respective movable ranges of the first and second tables in the first axial direction are expanded. Thus, the first and second tables can be moved smoothly to target positions thereof.

In the first aspect of the present invention, the first guiding device may include a first guiding mechanism that supports one end of the first table in the second axial direction and a second guiding mechanism that supports the other end of the first table, the second guiding device may include a third guiding mechanism that supports one end of the second table in the second axial direction and a fourth guiding mechanism that supports the other end of the second table. The first guiding mechanism may be arranged closest to one side in the second axial direction, the third guiding mechanism may be arranged, relative to the first guiding mechanism, second closest to the one side, the second guiding mechanism may be arranged, relative to the third guiding mechanism, third closest to the one side, and the fourth guiding mechanism may be arranged closest to the other side. As a result, the first guiding device can stably guide the first table with a pair of guiding mechanisms (the first and second guiding mechanisms). The second guiding device can stably guide the second table with a pair of guiding mechanisms (the third and fourth guiding mechanisms). Arrangement of the first, second, third, and fourth guiding mechanisms in the second axial direction can make the first and second guiding devices have substantially the same structure. As a result, the first and second tables each can be moved with the same level of moving accuracy.

In the first aspect of the present invention, the first and second tables may be moved such that an end of one side of the first upper surface and an end of the other side of the second upper surface come close to or come in contact with each other in the first axial direction. As a result, an object can be smoothly moved from one of the first and second upper surfaces to the other thereof.

In the first aspect of the present invention, the first guiding device may include a first slider connected to a first lower surface of the first table and a first rail along which the first slider moves, the second guiding device may include a second slider connected to a second lower surface of the second table and a second rail along which the second slider moves, the first and second rails may be arranged in parallel in the second axial direction, and the first and second sliders may be relatively movable in the first axial direction such that at least parts of the first and second sliders are arranged in the second axial direction. As a result, the respective movable ranges of the first and second tables are expanded, and the first and second tables can sufficiently come close to each other.

In the first aspect of the present invention, the first and second sliders may be separated while at least parts thereof are arranged in the second axial direction. As a result, the first and second sliders are not in contact with each other, and thus the first and second tables can be moved smoothly.

In the first aspect of the present invention, in the first axial direction, a dimension of the first table may be smaller than that of the first slider, and a dimension of the second table may be smaller than that of the second slider. As a result, the first and second tables are reduced in size and weight, and the first and second tables supported by the first and second sliders, respectively, can be moved smoothly.

In the first aspect of the present invention, the first and second sliders may each include a linear bearing. As a result, a pitching accuracy in a direction of the movement (first axial direction) is improved. Allowance for pitching moment can also be increased.

In the first aspect of the present invention, the table device may include: a linear scale that is arranged in parallel to the first and second rails; a first encoder head that is arranged on the first table and capable of detecting the linear scale; a second encoder head that is arranged on the second table and capable of the linear scale; and a driving system that moves at least one of the first table and the second table in the first axial direction based on detected values of the first and second encoder heads. As a result, information on the positions of the first and second tables is accurately detected, and the driving system can accurately move the first and second tables to the target positions.

A second aspect of the present invention provides a measuring device including the table device according to the first aspect.

According to the second aspect of the present invention, the measuring device can measure an object on the first or second table positioned at a target position. Therefore, the object can be measured accurately.

A third aspect of the present invention provides a machine tool including the table device according to the first aspect.

According to the third aspect of the present invention, the machine tool can machine an object on the first or second table positioned at a target position. Therefore, the object can be machined precisely.

### Advantageous Effects of Invention

With the table device according to the aspect of the present invention, the first and second tables can be smoothly moved to target positions thereof. With the measuring device and the machine tool according to the aspects of the present invention, degradation in performances can be suppressed.

### Brief Description of Drawings

FIG. 1 is a plane view illustrating an exemplary table device according to a first embodiment.
FIG. 2 is a side view illustrating the exemplary table device according to the first embodiment.
FIG. 3 is a side view illustrating the exemplary table device according to the first embodiment.
FIG. 4 is a diagram illustrating an exemplary guiding device according to the first embodiment.
FIG. 5 is a plane view illustrating an exemplary table device according to a comparative example.
FIG. 6 is a side view illustrating the exemplary table device according to the comparative example.
FIG. 7 is a plane view illustrating an exemplary table device according to a second embodiment.
FIG. 8 is a side view illustrating the exemplary table device according to the second embodiment.
FIG. 9 is a side view illustrating the exemplary table device according to the second embodiment.
FIG. 10 is a plane view illustrating an exemplary table device according to a third embodiment.
FIG. 11 is a side view illustrating the exemplary table device according to the third embodiment.
FIG. 12 is a plane view illustrating an exemplary table device according to a fourth embodiment.
FIG. 13 is a side view illustrating the exemplary table device according to the fourth embodiment.
FIG. 14 is a side view illustrating the exemplary table device according to the fourth embodiment.
FIG. 15 is a diagram illustrating an exemplary carrier device and a semiconductor manufacturing device according to a fifth embodiment.
FIG. 16 is a diagram illustrating an exemplary carrier device and measuring device according to the fifth embodiment.
FIG. 17 is a diagram illustrating an exemplary machine tool according to the fifth embodiment.

### Description of Embodiments

Embodiments according to the present invention will be described below with reference to the drawings, but the present invention is not limited thereto. Requirements of each embodiment described below can be combined appropriately. In some cases, a part of components may not be used. In the following descriptions, an XYZ orthogonal coordinate system is used, and positional relations between units will be described with reference to this XYZ orthogonal coordinate system. It is assumed that a direction parallel to a first axis (X-axis) in a predetermined plane is an X-axis direction, a direction parallel to a second axis (Y-axis) in the predetermined plane perpendicular to the X-axis is a Y-axis direction, and a direction parallel to a third axis (Z-axis) perpendicular to each of the X-axis and Y-axis is a Z-axis direction. Rotational (inclination) directions around the X-axis, Y-axis, and Z-axis are assumed to be θX, θY, and θZ directions, respectively. The X-axis is perpendicular to a YZ plane. The Y-axis is perpendicular to an XZ plane. The Z-axis is perpendicular to an XY plane. The XY plane is parallel to the predetermined plane. In the present embodiment, the XY plane is assumed to be parallel to a horizontal plane. The Z-axis direction is a vertical direction.

### <First embodiment>

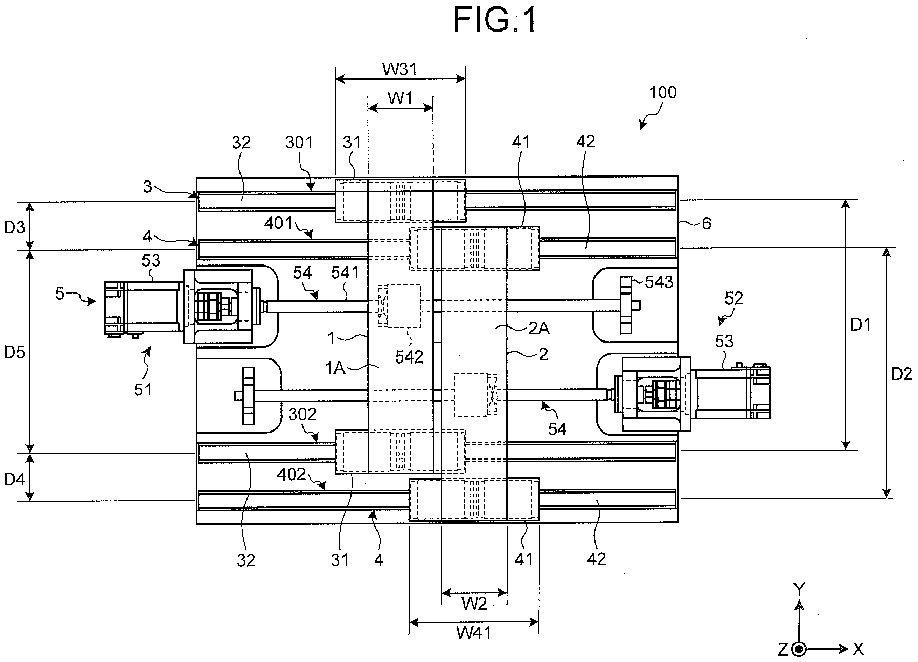

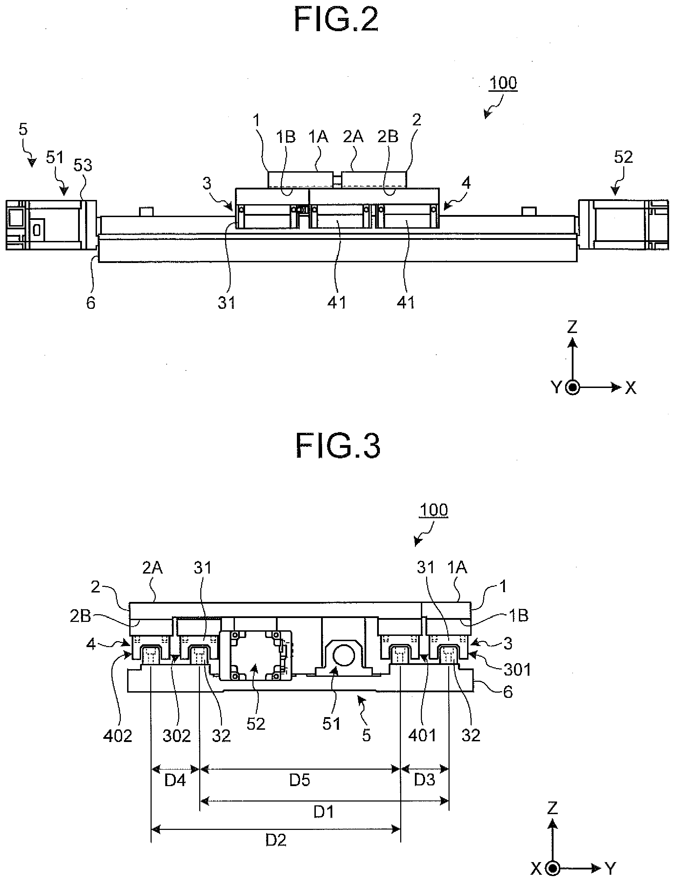

A first embodiment will be described below. FIG. 1 is a plane view of a table device 100 according to the present embodiment as viewed from a +Z direction. FIG. 2 is a side view of the table device 100 according to the present embodiment as viewed from a -Y direction. FIG. 3 is a side view of the table device 100 according to the present embodiment as viewed from a +X direction.

As illustrated in FIGS. 1 to 3, the table device 100 includes a first table 1, a second table 2, a first guiding device 3 that guides the first table 1 in the X-axis direction, a second guiding device 4 that guides the second table 2 in the X-axis direction, and a driving system 5 that can move the first table 1 and the second table 2 in the X-axis direction.

The table device 100 includes a base member 6. The base member 6 is arranged on, for example, a floor surface of a facility (such as a factory) where the table device 100 is installed. At least a part of the first guiding device 3 is arranged on an upper surface of the base member 6. At least a part of the second guiding device 4 is arranged on the upper surface of the base member 6. The first table 1 and the second table 2 are movable above the base member 6.

The first table 1 is movable while supporting an object. The first table 1 has an upper surface 1A facing the +Z direction and a lower surface 1B facing an opposite direction (-Z direction) of the upper surface 1A. The object is placed on the upper surface 1A of the first table 1. The upper surface 1A can support the object. In the present embodiment, the upper surface 1A and the lower surface 1B each are parallel to an XY plane.

The second table 2 is movable while supporting an object. The second table 2 has an upper surface 2A facing the +Z direction and a lower surface 2B facing an opposite direction (-Z direction) of the upper surface 2A. The object is placed on the upper surface 2A of the second table 2. The upper surface 2A can support the object. In the present embodiment, the upper surface 2A and the lower surface 2B each are parallel to the XY plane.

The first table 1 and the second table 2 are arranged in the X-axis direction. The first table 1 is arranged on a -X side of the second table 2. The first table 1 is movable in an area (space) on the -X side of the second table 2. The second table 2 is movable in an area (space) on the +X side of the first table 1.

As illustrated in FIG. 1, in the present embodiment, the first table 1 and the second table 2 each are in a rectangular shape in the XY plane. The first table 1 and the second table 2 each are longer in the Y-axis direction. A +X side end of the first table 1 and a - X side end of the second table 2 can face each other.

In the present embodiment, the upper surfaces 1A and 2A are arranged substantially at the same height. The upper surfaces 1A and 2A each are plane (flat). The upper surfaces 1A and 2A are arranged in the same plane (arranged to be flush).

The first guiding device 3 and the second guiding device 4 are arranged in the Y-axis direction. The first guiding device 3 and the second guiding device 4 are adjacent to each other in the Y-axis direction. The first guiding device 3 guides the first table 1 in the X-axis direction and does not guide the second table 2. The second guiding device 4 guides the second table 2 in the X-axis direction and does not guide the first table 1. The first guiding device 3 is not in contact with the second guiding device 4 and the second table 2. The second guiding device 4 is not in contact with the first guiding device 3 and the first table 1.

The first guiding device 3 includes a guiding mechanism 301 that supports one end (a +Y side end) of the first table 1 in the Y-axis direction and a guiding mechanism 302 that supports the other end (a -Y side end) of the first table 1.

The second guiding device 4 includes a guiding mechanism 401 that supports one end (a +Y side end) of the second table 2 in the Y-axis direction and a guiding mechanism 402 that supports the other end (a -Y side end) of the second table 2.

The guiding mechanisms 301, 302, 401, and 402 are arranged in the Y-axis direction. Of the guiding mechanisms 301, 302, 401, and 402, the guiding mechanism 301 is arranged closest to the +Y side, the guiding mechanism 401 is arranged, relative to the guiding mechanism 301, second closest to the +Y side, and the guiding mechanism 302 is arranged, relative to the guiding mechanism 401, third closest to the +Y side. The guiding mechanism 402 is arranged closest to the -Y side.

The guiding mechanism 301 of the first guiding device 3 has a slider 31 connected to the lower surface 1B of the first table 1 and a rail 32 along which the slider 31 moves. Similarly, the guiding mechanism 302 of the first guiding device 3 has a slider 31 connected to the lower surface 1B of the first table 1 and a rail 32 along which the slider 31 moves. The slider 31 of the guiding mechanism 301 is fixed to the +Y side end of the lower surface 1B of the first table 1. The slider 31 of the guiding mechanism 302 is fixed to the -Y side end of the lower surface 1B of the first table 1.

A dimension W1 of the first table 1 is smaller than a dimension W31 of the slider 31 in the X-axis direction. The first table 1 is supported by a central part of the slider 31 in the X-axis direction. The first table 1 is supported by the slider 31 such that, in the X-axis direction, a center of the first table 1 corresponds with the center of the slider 31.

The rail 32 is arranged on the upper surface of the base member 6. The rail 32 is long in the X-axis direction. The first guiding device 3 has two rails 32 arranged in the Y-axis direction. The two rails 32 are arranged in parallel. The slider 31 of the guiding mechanism 301 moves along the rail 32 thereof. The slider 31 of the guiding mechanism 302 moves along the rail 32 thereof.

The guiding mechanism 401 of the second guiding device 4 has a slider 41 connected to the lower surface 2A of the second table 2 and a rail 42 along which the slider 41 moves. Similarly, the guiding mechanism 402 of the second guiding device 4 has a slider 41 connected to the lower surface 2A of the second table 2 and a rail 42 along which the slider 41 moves. The slider 41 of the guiding mechanism 401 is fixed to the +Y side end of the lower surface 2B of the second table 2. The slider 41 of the guiding mechanism 402 is fixed to the -Y side end of the lower surface 2B of the second table 2.

A dimension W2 of the second table 2 is smaller than a dimension W41 of the slider 41 in the X-axis direction. The second table 2 is supported by a central part of the slider 41 in the X-axis direction. The second table 2 is supported by the slider 41 such that a center of the second table 2 corresponds with the center of the slider 41 in the X-axis direction.

The rail 42 is arranged on the upper surface of the base member 6. The rail 42 is long in the X-axis direction. The second guiding device 4 has two rails 42 arranged in the Y-axis direction. The two rails 42 are arranged in parallel. The slider 41 of the guiding mechanism 401 moves along the rail 42 thereof. The slider 41 of the guiding mechanism 402 moves along the rail 42 thereof.

The rails 32 and 42 are arranged in the Y-axis direction. The rails 32 and 42 are arranged in parallel. In the present embodiment, a distance D1 between the rails 32 of the guiding mechanisms 301 and 302 and a distance D2 between the rails 42 of the guiding mechanisms 401 and 402 are equal in the Y-axis direction. The rail 42 of the guiding mechanism 401 is arranged between the rails 32 of the guiding mechanisms 301 and 302. The rail 32 of the guiding mechanism 302 is arranged between the rails 42 of the guiding mechanisms 401 and 402. A distance D3 between the rail 32 of the guiding mechanisms 301 and the rail 42 of the guiding mechanism 401 and a distance D4 between the rail 32 of the guiding mechanism 302 and the rail 42 of the guiding mechanism 402 are equal in the Y-axis direction. A distance D5 between the rail 42 of the guiding mechanism 401 and the rail 32 of the guiding mechanism 302 is longer than the distances D3 and D4.

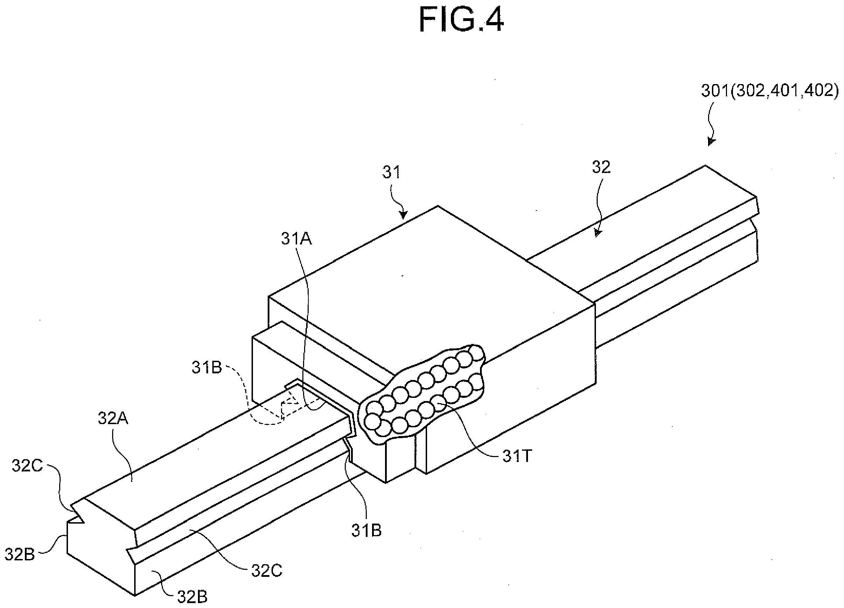

FIG. 4 is a perspective view illustrating an example of the guiding mechanism 301. The guiding mechanism 301 includes a linear guiding mechanism. The guiding mechanism 301 includes the rail 32 arranged on the base member 6 and the slider (block) 31 arranged below the first table 1 and movable along the rail 32. In the present embodiment, the slider 31 includes a linear bearing. In the present embodiment, the slider 31 includes a linear rolling bearing. The rolling bearing has a rolling element. The rolling element includes a ball and/or a roller. That is, the rolling bearing includes one or both of a ball bearing and a roller bearing. In the present embodiment, the slider 31 includes a linear ball bearing.

The rail 32 has a surface 32A facing upward, side surfaces 32B arranged on both sides of the surface 32A, and a groove 32C formed on each side 32B. The slider 31 has a first opposite surface 31A that can face the surface 32A of the rail 32, second opposite surfaces 31B that can face the sides 32B of the rail 32, and a rolling element (balls) 31T including at least a part arranged in the groove 32C of the rail 32. The balls 31T roll in contact with an inner surface of the groove 32C. Rolling of the balls 31T along the groove 32C allows the slider 31 to move smoothly along the rail 32.

Structures and operating principles of the guiding mechanisms 302, 401, and 402 are equivalent to those of the guiding mechanism 301. That is, the slider 41 includes a linear bearing. Descriptions of the guiding mechanisms 302, 401, and 402 will be omitted.

One (single), or two or more sliders 31 may be provided for one rail 32. The same applies to the slider 41.

As illustrated in FIGS. 1 to 3, the driving system 5 has a first driving device 51 that moves the first table 1 in the X-axis direction and a second driving device 52 that moves the second table 2 in the X-axis direction.

The first driving device 51 includes an actuator 53 that generates power and a power transmission device 54 that transmits the power (driving force) of the actuator 53 to the first table 1. The actuator 53 and the first table 1 are connected to each other through the power transmission device 54.

The actuator 53 includes a rotating motor and operates with electric power to be supplied. The power transmission device 54 converts a rotational movement of the actuator 53 into a linear movement. In the present embodiment, a shaft of the actuator (rotating motor) 53 rotates in a θX direction. The power transmission device 54 converts the rotational movement in the θX direction into the linear movement in the X-axis direction and transmits the linear movement to the first table 1. The first table 1 moves in the X-axis direction by the power of the actuator 53 transmitted through the power transmission device 54.

In the present embodiment, at least a part of the first driving device 51 including the power transmission device 54 is arranged between the guiding mechanisms 302 and 401 on the base member 6.

In the present embodiment, the power transmission device 54 includes a ball screw. The ball screw includes a screw shaft 541 that rotates by operation of the actuator 53, a nut 542 connected to the first table 1 and arranged around the screw shaft 541, and a ball arranged between the screw shaft 541 and the nut 542. The screw shaft 541 of the ball screw is rotatably supported by a supporting bearing 543. In the present embodiment, the screw shaft 541 of the ball screw rotates in the θX direction. The rotation of the screw shaft 541 in the θX direction causes the nut 542 and the first table 1 to which the nut 542 is connected to move in the X-axis direction (move linearly).

When the actuator 53 rotates the screw shaft 541 of the ball screw in one direction, the rotation of the screw shaft 541 moves the first table 1 in the +X direction. When the actuator 53 rotates the screw shaft 541 of the ball screw in an opposite direction, the rotation of the screw shaft 541 moves the first table 1 in a -X direction. That is, a moving direction of the first table 1 in the X-axis direction (+X direction or -X direction) is determined based on a rotational direction of the actuator 53 (rotational direction of the screw shaft 541 of the ball screw).

The second driving device 52 includes an actuator 53 that generates power and a power transmission device 54 that transmits the power (driving force) of the actuator 53 to the second table 2. The actuator 53 and the second table 2 are connected to each other through the power transmission device 54. Structures and operating principles of the second driving device 52 are equivalent to those of the first driving device 51. Descriptions of the second driving device 52 will be omitted.

The first driving device 51 and the second driving device 52 can be operated separately. The driving system 5 can separately move the first table 1 and the second table 2 by the first driving device 51 and the second driving device 52. The driving system 5 may move simultaneously the first table 1 and the second table 2. The driving system 5 may stop the second table 2 for at least a part of a period during which the first table 1 is moved. The driving system 5 may stop the first table 1 for at least a part of a period during which the second table 2 is moved.

As illustrated in FIG. 1, the first table 1 and the second table 2 can move such that the +X side end of the upper surface 1A and the -X side end of the upper surface 2A come close to each other. The first table 1 and the second table 2 may be moved such that the +X side end of the upper surface 1A and the -X side end of the upper surface 2A may come in contact with each other. The driving system 5 can move the first table 1 and the second table 2 together in the X-axis direction while the +X side end of the upper surface 1A and the -X side end of the upper surface 2A come close to or come in contact with each other.

As illustrated in FIG. 1, the sliders 31 and 41 can relatively move in the X-axis direction such that at least parts of the sliders 31 and 41 are arranged in the Y-axis direction. The sliders 31 and 32 are arranged such that the sliders 31 and 41 are not in contact with each other even when they relatively move in the X-axis direction. As illustrated in FIG. 1, the sliders 31 and 41 are separated even when at least parts of the sliders 31 and 41 are arranged in the Y-axis direction.

Next, an example of operation of the above table device 100 will be described. When the first driving device 51 operates, the first table 1 moves in the X-axis direction. Guided by the first guiding device 3, the first table 1 moves smoothly in the X-axis direction. The first table 1 is moved along a target track (desired track) in the X-axis direction by the first guiding device 3. In the present embodiment, the first table 1 can move straight in the X-axis direction by the first guiding device 3.

When the second driving device 52 operates, the second table 2 moves in the X-axis direction. Guided by the second guiding device 4, the second table 2 moves smoothly in the X-axis direction. The second table 2 is moved along a target track (desired track) in the X-axis direction by the second guiding device 4. In the present embodiment, the second table 2 can move straight in the X-axis direction by the second guiding device 4.

In the present embodiment, the first guiding device 3 and the second guiding device 4 are arranged shifted in the Y-axis direction. In the present embodiment, the first table 1 and the slider 31 can move so as not to come in contact with the second guiding device 4 including the slider 41 and the rail 42. The second table 2 and the slider 41 can move so as not to come in contact with the first guiding device 3 including the slider 31 and the rail 32.

Thus, as illustrated in FIG. 1, the first table 1 and the second table 2 can move so as to come close to or come in contact with each other.

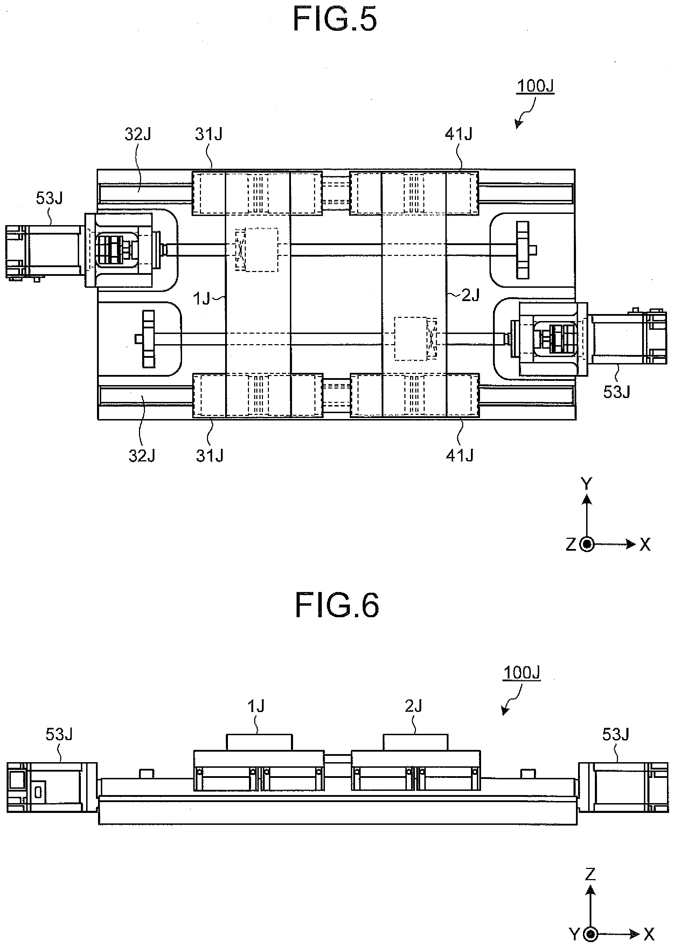

FIGS. 5 and 6 are diagrams illustrating an example of a table device 100J according to a comparative example. FIG. 5 is a plane view of the table device 100J according to the comparative example as viewed from the +Z direction. FIG. 6 is a side view of the table device 100J according to the comparative example as viewed from the -Y direction.

The table device 100J has a first table 1J and a second table 2J. A slider 31J is connected to the first table 1J. A slider 41J is connected to the second table 2J. The sliders 31J and 41J move along a rail 32J.

As with the table device 100J according to the comparative example, when the slider 31J connected to the first table 1J and the slider 41J connected to the second table 2J share one rail 32J, the sliders 31J and 41J may touch (come in contact with) each other. As a result, movable ranges of the first table 1J and the second table 2J in the X-axis direction are limited. The limitation of the movable ranges may make it difficult for the first table 1J and the second table 2J to come close to or come in contact with each other.

Increasing dimensions of the first table 1J and the second table 2J in the X-axis direction may make it possible for the first table 1J and the second table 2J to come close to or come in contact with each other even when the movable ranges of the first table 1J and the second table 2J are narrow. However, enlargement of the first table 1J and the second table 2J requires an actuator 53J to generate excessive power, which may result in consumption of a large amount of energy (electric power). The enlargement of the first table 1J and the second table 2J may cause deterioration in positioning accuracy thereof.

As described above with reference to FIGS. 1 to 4, in the present embodiment, the rail 32 is arranged for the slider 31 connected to the first table 1. The rail 42 is arranged for the slider 41 connected to the second table 2. That is, the sliders 31 and 41 are provided with dedicated rails 32 and 42, respectively. The sliders 31 and 41 do not share one rail. Therefore, limitation of the movable ranges of the first table 1 and the second table 2 is suppressed. This allows the first table 1 and the second table 2 to come close to or come in contact with each other without enlargement thereof. Thus, the first table 1 and the second table 2 can be moved with a high level of positioning accuracy and without enormous energy consumption.

As described above, according to the present embodiment, the first guiding device 3 that guides the first table 1 in the X-axis direction and the second guiding device 4 that guides the second table 2 in the X-axis direction are arranged shifted in the Y-axis direction. Therefore, limitation of the movable ranges of the first table 1 and the second table 2 in the X-axis direction is suppressed. Thus, the first table 1 and the second table 2 can be smoothly moved to target positions.

According to the present embodiment, the first guiding device 3 has the guiding mechanisms 301 and 302. The second guiding device 4 has the guiding mechanisms 401 and 402. Arrangement of those four guiding mechanisms 301, 302, 401, and 402 in the Y-axis direction causes the first table 1 to be stably guided by a pair of guiding mechanisms 301 and 302. The second table 2 is stably guided by a pair of guiding mechanisms 401 and 402. The first guiding device 3 and the second guiding device 4 have substantially the same structure. As a result, the first table 1 and the second table 2 each can be moved with the same level of moving accuracy.

According to the present embodiment, the first table 1 and the second table 2 can be moved such that they come close to or come in contact with each other. Consequently, for example, it is possible to smoothly move the object supported by the first table 1 to the second table 2 and move the object supported by the second table 2 to the first table 1 while the first table 1 and the second table 2 are close to or come in contact with each other.

In the present embodiment, in moving the first table 1 and the second table 2, structures and positional relationships of the first guiding device 3 and the second guiding device 4 are predetermined such that the first table 1 and the slider 31 are not in contact with the slider 41 and the rail 42, and the second table 2 and the slider 41 are not in contact with the slider 31 and the rail 32. Thus, the first table 1 and the second table 2 can be moved smoothly.

In the present embodiment, the dimension W1 of the first table 1 is smaller than the dimension W31 of the slider 31, and the dimension W2 of the second table 2 is smaller than the dimension W41 of the slider 41 in the X-axis direction. The reduction in size and weight of the first table 1 and the second table 2 allows the driving system 5 to smoothly move the first table 1 supported by the slider 31 and the second table 2 supported by the slider 41 without enormous energy. The reduction in size and weight of the first table 1 and the second table 2 also suppresses deterioration in positioning accuracy thereof.

### <Second embodiment>

A second embodiment will be described below. In the following descriptions, components that are the same as or equivalent to those in the above embodiment are denoted by the same reference signs and the descriptions thereof will be simplified or omitted.

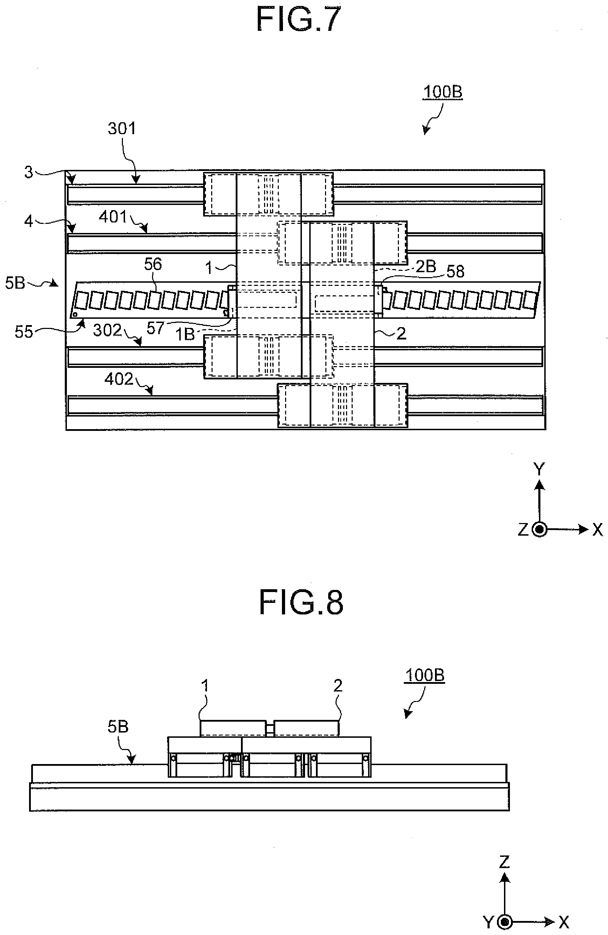

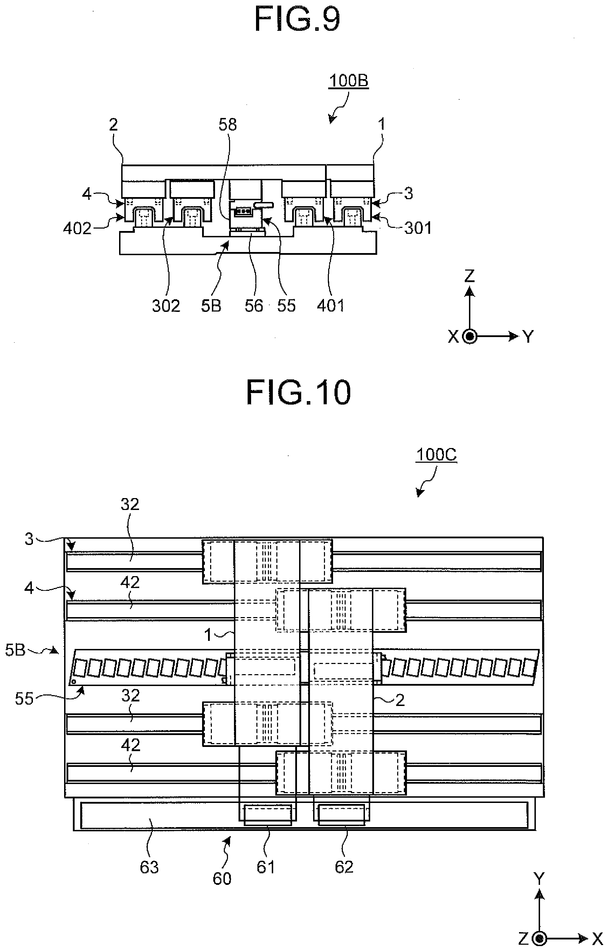

FIG. 7 is a plane view of a table device 100B according to the present embodiment as viewed from the +Z direction. FIG. 8 is a side view of the table device 100B according to the present embodiment as viewed from the -Y direction. FIG. 9 is a side view of the table device 100B according to the present embodiment as viewed from the +X direction.

The table device 100B includes a first table 1, a second table 2, a first guiding device 3 that guides the first table 1 in the X-axis direction, a second guiding device 4 that guides the second table 2 in the X-axis direction, and a driving system 5B that moves at least one of the first table 1 and the second table 2 in the X-axis direction.

In the present embodiment, the driving system 5B has a linear motor 55. At least a part of the linear motor 55 is arranged between guiding mechanisms 302 and 401 on a base member 6.

The linear motor 55 includes a stator 56 provided on an upper surface of the base member 6, a mover 57 that is fixed on a lower surface 1B of the first table 1 and moves with respect to the stator 56, and a mover 58 that is fixed on a lower surface 2B of the second table 2 and moves with respect to the stator 56. In the present embodiment, the stator 56 has a plurality of coils. The movers 57 and 58 each have a magnet. That is, in the present embodiment, the linear motor 55 is a moving magnet type linear motor. In the linear motor 55, the stator 56 may have a magnet, and the movers 57 and 58 each may have a coil. That is, the linear motor 55 may be a moving coil type linear motor.

As described above, the driving system 5B may have the linear motor 55. According to the present embodiment, the mover 57 connected to the first table 1 and the mover 58 connected to the second table 2 share one stator 56. Therefore, the table device 100B can be reduced in size.

### <Third embodiment>

A third embodiment will be described below. In the following descriptions, components that are the same as or equivalent to those in the above embodiment are denoted by the same reference signs and the descriptions thereof will be simplified or omitted.

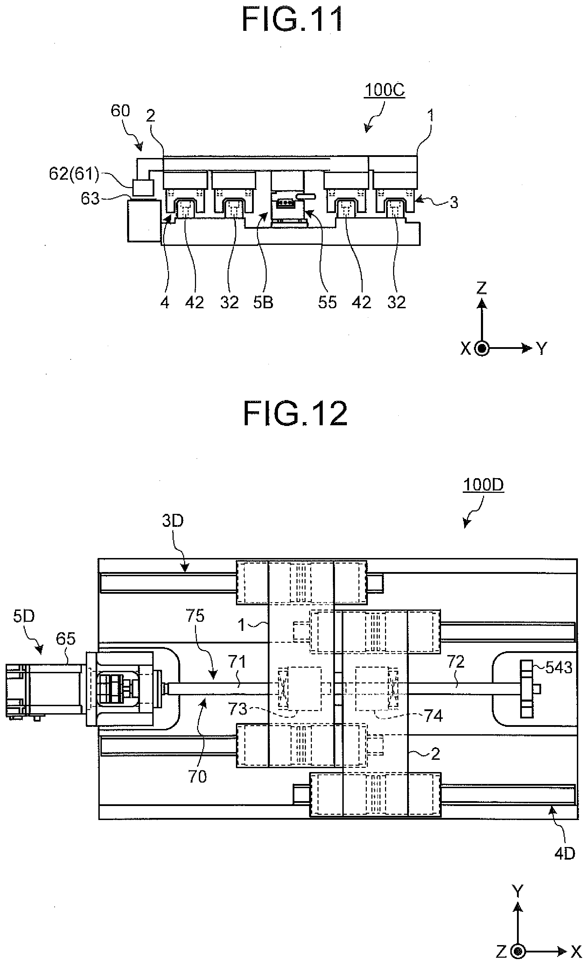

FIG. 10 is a plane view of a table device 100C according to the present embodiment as viewed from the +Z direction. FIG. 11 is a side view of the table device 100C according to the present embodiment as viewed from the +X direction.

The table device 100C includes a first table 1, a second table 2, a first guiding device 3 that guides the first table 1 in the X-axis direction, a second guiding device 4 that guides the second table 2 in the X-axis direction, and a driving system 5B that moves at least one of the first table 1 and the second table 2 in the X-axis direction. As with the above embodiment, the driving system 5B has a linear motor 55.

In the present embodiment, the table device 100C includes a detecting system 60 that detects positions of the first table 1 and the second table 2 in the X-axis direction. In the present embodiment, the detecting system 60 includes a linear encoder system. The detecting system

60 includes a linear scale 63 that is arranged outside an upper surface of a base member 6 and in parallel to rails 32 and 42, an encoder head 61 that is arranged on the first table 1 and detects the linear scale 63, and an encoder head 62 that is arranged on the second table 2 and detects the linear scale 63. The encoder head 61 detects a position of the first table 1 in the X-axis direction by irradiating the linear scale 63 with detection light and receiving the detection light reflected by the linear scale 63. The encoder head 62 detects a position of the second table 2 in the X-axis direction by irradiating the linear scale 63 with detection light and receiving the detection light reflected by the linear scale 63.

Detected values by the encoder heads 61 and 62 are output to a controller of the driving system 5B. The driving system 5B moves the first table 1 in the X-axis direction based on the value detected by the encoder head 61 and moves the second table 2 in the X-axis direction based on the value detected by the encoder head 62.

As described above, according to the present embodiment, information on the positions of the first table 1 and the second table 2 can be detected accurately by the detecting system 60 including the encoder system. The driving system 5B can precisely move the first table 1 and the second table 2 to target positions based on detection results of the detecting system 60.

The detecting system 60 may be arranged in the table device 100 described in the first embodiment above. A driving system 5 including a rotating motor and a ball screw may move the first table 1 and the second table 2 based on the detection results of the detecting system 60. In a case where the driving system 5 has a rotating system such as the rotating motor (a servomotor and a megatorque motor, for example), a detecting system including a rotary encoder or a resolver that can detect a rotational position (rotation amount) of the rotating system may be provided. The rotational position of the rotating system correlates with the positions of the first table 1 and the second table 2 in the X-axis direction. Therefore, the positions of the first table 1 and the second table 2 may be derived based on the detection results of the detecting system.

### <Fourth embodiment>

A fourth embodiment will be described below. In the following descriptions, components that are the same as or equivalent to those in the above embodiment are denoted by the same reference signs and the descriptions thereof will be simplified or omitted.

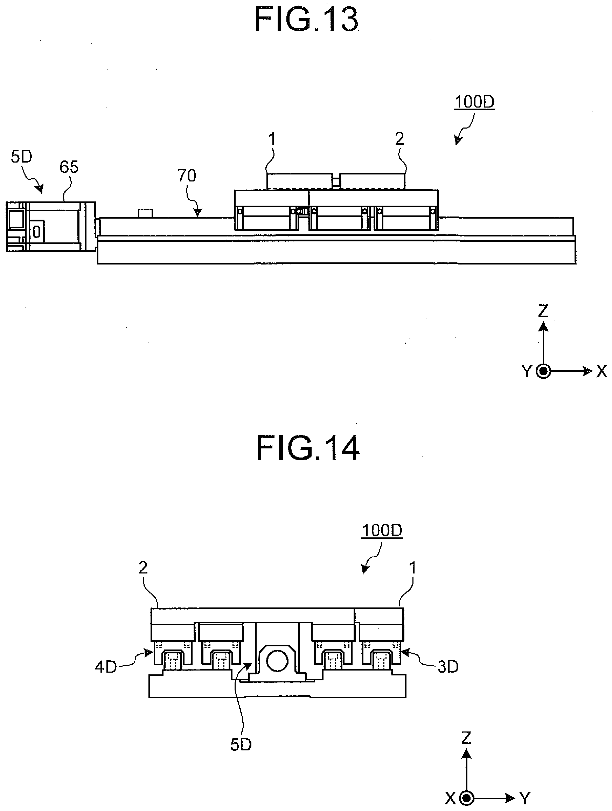

FIG. 12 is a plane view of a table device 100D according to the present embodiment as viewed from the +Z direction. FIG. 13 is a side view of the table device 100D according to the present embodiment as viewed from the -Y direction. FIG. 14 is a side view of the table device 100D according to the present embodiment as viewed from the +X direction.

The table device 100D includes a first table 1, a second table 2, a first guiding device 3D that guides the first table 1 in the X-axis direction, a second guiding device 4D that guides the second table 2 in the X-axis direction, and a driving system 5D that moves at least one of the first table 1 and the second table 2 in the X-axis direction.

In the present embodiment, the driving system 5D includes an actuator 65 that generates power and a power transmission device 70 that transmits the power (driving force) of the actuator 65 to each of the first table 1 and the second table 2. The actuator 65 is connected to each of the first table 1 and the second table 2 through the power transmission device 70.

The actuator 65 includes a rotating motor and operates with electric power to be supplied. The power transmission device 70 converts a rotational movement of the actuator 65 into a linear movement. In the present embodiment, a shaft of the actuator (rotating motor) 65 rotates in a θX direction. The power transmission device 70 converts the rotational movement in the θX direction into the linear movement in the X-axis direction and transmits the linear movement to each of the first table 1 and the second table 2. The first table 1 and the second table 2 each move in the X-axis direction by the power of the actuator 65 transmitted through the power transmission device 70.

In the present embodiment, the power transmission device 70 includes a ball screw 75, so-called a right-left screw. The right-left screw 75 has a right screw part 71 and a left screw part 72. The power transmission device 70 has also a nut 73 connected to the first table 1 and arranged around the right screw part 71, and a nut 74 4 connected to the second table 2 and arranged around the left screw part 72. A ball is arranged between the right screw part 71 and the nut 73. A ball is arranged between the left screw part 72 and the nut 74. The right-left screw 75 is rotatably supported by a supporting bearing 543.

The right-left screw 75 rotates in the θX direction. The rotation of the right-left screw 75 in the θX direction allows the nut 73 and the first table 1 to which the nut 73 is connected to move (linearly move) in the X-axis direction. The rotation of the right-left screw 75 in the θX direction also allows the nut 74 and the second table 2 to which the nut 74 is connected to move (linearly move) in the X-axis direction.

As described above, the driving system 5D may have the right-left screw 75.

The table device 100D according to the present embodiment may include the detecting system 60 described in the above embodiment and detecting positions of the first table 1 and the second table 2. The driving system 5D may move the first table 1 and the second table 2 based on detection results of the detecting system 60.

### <Fifth embodiment>

A fifth embodiment will be described below. In the following descriptions, components that are the same as or equivalent to those in the above embodiment are denoted by the same reference signs and the descriptions thereof will be simplified or omitted.

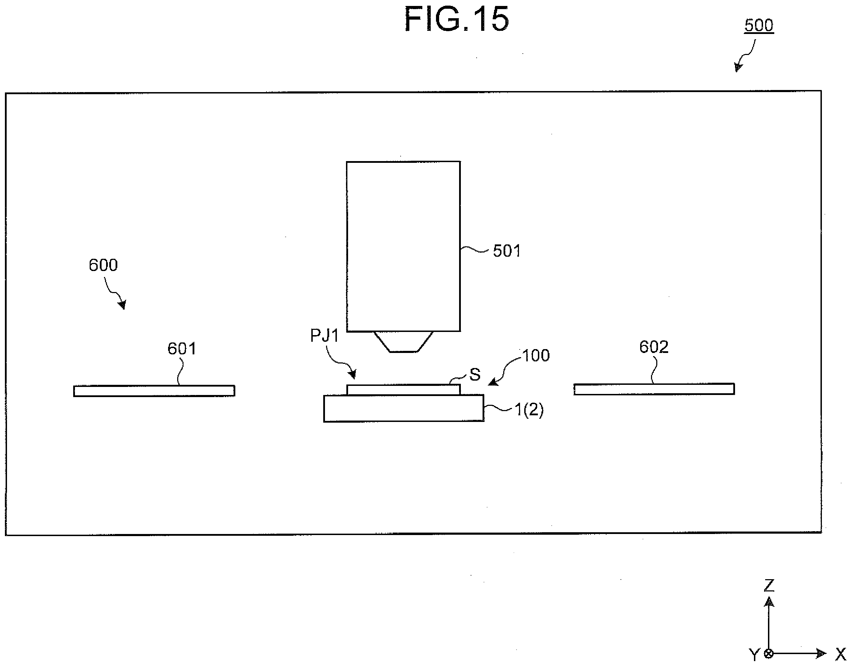

FIG. 15 is a diagram illustrating an example of a semiconductor manufacturing device 500 including a table device 100 according to the present embodiment. The semiconductor manufacturing device 500 includes semiconductor device manufacturing device that can manufacture semiconductor devices. The semiconductor manufacturing device 500 includes a carrier device 600 that can carry an object S for manufacturing a semiconductor device. The carrier device 600 includes the table device 100 according to the present embodiment.

FIG. 15 illustrates the simplified table device 100. For ease of description, in the following descriptions, of a first table 1 and a second table 2 included in the table device 100, an example where the first table 1 supports the object S will be mainly described. The second table 2 may support the object S.

In the present embodiment, the object S is a substrate for manufacturing a semiconductor device. A semiconductor device is manufactured from the object S.
The object S may include a semiconductor wafer or a glass sheet. A semiconductor device is manufactured by formation of a device pattern (wiring pattern) on the object S.

The semiconductor manufacturing device 500 subjects the object S positioned at a processing position PJ1 to processing for forming the device pattern. The table device 100 positions the object S supported by the first table 1 (or the second table 2) at the processing position PJ1. The carrier device 600 includes a carrying-in device 601 that can carry (carry in) the object S to the first table 1 of the table device 100, and a carrying-out device 602 that can carry (carry out) the object S from the first table 1. The object S before processing is carried (carried in) to the first table 1 by the carrying-in device 601. The object S supported by the first table 1 is carried to the processing position PJ1 by the table device 100. The object S after processing is carried (carried out) from the first table 1 by the carrying-out device 602.

The table device 100 moves the object S supported by the first table 1 to the processing position PJ1 by moving the first table 1. As described in the above embodiment, the first table 1 is guided by the first guiding device 3. Therefore, the table device 100 can move the first table 1 along a target track and position the object S supported by the first table 1 at the processing position (target position) PJ1.

For example, in a case where the semiconductor manufacturing device 500 includes an measurement device that measures the device pattern of the object S through an optical system 501, the processing position PJ1 includes a focus position (measurement position) of the optical system 501. The object S is positioned at the processing position PJ1, so that the semiconductor manufacturing device 500 can obtain, through the optical system 501, an image of the device pattern formed on the object S. In a case where the semiconductor manufacturing device 500 includes a film forming device that forms a film on the object S, the processing position PJ1 is a position where materials for forming a film can be supplied. The object S is positioned at the processing position PJ1, so that a film for forming the device pattern is formed on the object S.

After the object S is processed at the processing position PJ1, the object S after processing is carried from the first table 1 by the carrying-out device 602. The object S carried (carried out) by the carrying-out device 602 is carried to a processing device for a post-process.

In the present embodiment, the table device 100 can position the object S at the processing position (target position) PJ1. Therefore, manufacturing defective products is suppressed. That is, deterioration in positioning accuracy of the object S in the semiconductor manufacturing device 500 is suppressed by the table device 100, and thus, generation of defective products is suppressed.

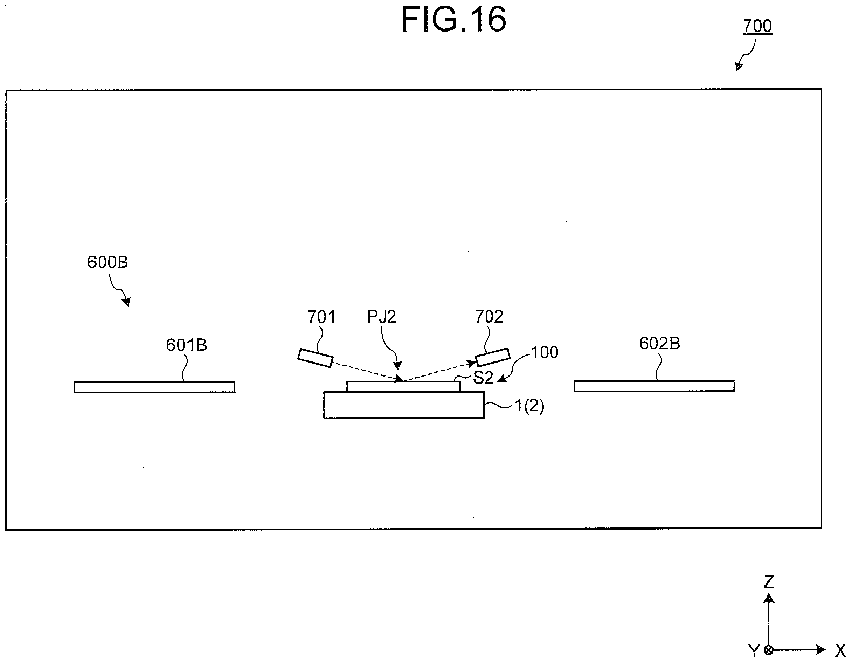

FIG. 16 is a diagram illustrating an example of a measuring device 700 including the table device 100 according to the present embodiment. The measuring device 700 measures an object (semiconductor device) S2 manufactured by the semiconductor manufacturing device 500. The measuring device 700 includes a carrier device 600B that can carry the object S2. The carrier device 600B includes the table device 100 according to the present embodiment.

FIG. 16 illustrates the simplified table device 100. For ease of description, in the following descriptions, of the first table 1 and the second table 2 included in the table device 100, an example where the first table 1 supports the object S2 will be mainly described. The second table 2 may support the object S2.

The measuring device 700 measures the object S2 positioned at a measuring position PJ2. The table device 100 positions the object S2 supported by the first table 1 (or the second table 2) at the measuring position PJ2. The carrier device 600B includes a carrying-in device 601B that can carry (carry in) the object S2 to the first table 1 of the table device 100, and a carrying-out device 602B that can carry (carry out) the object S2 from the first table 1. The object S2 before measurement is carried (carried in) to the first table 1 by the carrying-in device 601B. The object S2 supported by the first table 1 is carried to the measuring position PJ2 by the table device 100. The object S2 after measurement is carried (carried out) from the first table 1 by the carrying-out device 602B.

The table device 100 moves the object S2 supported by the first table 1 to the measuring position PJ2 by moving the first table 1. As described in the above embodiment, the first table 1 is guided by the first guiding device 3. Therefore, the table device 100 can move the first table 1 along the target track and position the object S2 supported by the first table 1 at the measuring position (target position) PJ2.

In the present embodiment, the measuring device 700 optically measures the object S2 using detection light. The measuring device 700 includes an irradiating device 701 that can emit the detection light and a light receiving device 702 that can receive at least a part of the detection light emitted from the irradiating device 701 and reflected by the object S2. In the present embodiment, the measuring position PJ2 includes an irradiation position of the detection light. The object S2 is positioned at the measuring position PJ2, so that conditions of the object S2 can be optically measured.

After the object S2 is measured at the measuring position PJ2, the object S2 after measurement is carried from the first table 1 by the carrying-out device 602B.

In the present embodiment, the table device 100 can position the object S2 at the measuring position (target position) PJ2. Therefore, generation of measurement failures can be suppressed. That is, the measuring device 700 can appropriately determine whether or not the object S2 is defective. This prevents a defective object S2 from being carried to the post-process or being shipped, for example.

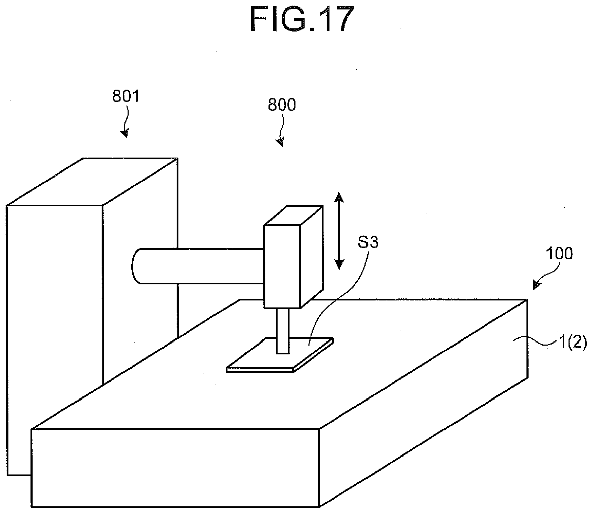

FIG. 17 is a diagram illustrating an example of a machine tool 800 including the table device 100 according to the present embodiment. The machine tool 800 machines an object S3. The machine tool 800 is a machining center and has a table device 100 and a machining head 801. The machining head 801 has a machining tool and machines the object S3 fixed to the first table 1 (or the second table 2) of the table device 100 by the machining tool. The machining head 801 is a mechanism for cutting the object S3. The machining head 801 moves the machining tool in the Z-axis direction perpendicular to a moving direction of the first table 1 (or the second table 2).

The machine tool 800 can relatively move the machining tool and the object S3 by moving the object S3 in an XY plane by the table device 100 and moving the machining head 801 in the Z-axis direction.

The machine tool 800 can machine the object S3 on the first table 1 or the second table 2 positioned at the target position. Therefore, the object S3 can be precisely machined.

In the present embodiment, it is assumed that the first table 1 and the second table 2 move in the X-axis direction in a horizontal plane. In the present embodiment, the first table 1 and the second table 2 may be moved in a direction inclining to the horizontal plane. That is, the XY plane may be parallel or inclined to the horizontal plane.

### Reference Signs List

- 1: FIRST TABLE
- 1A: UPPER SURFACE
- 1B: LOWER SURFACE
- 2: SECOND TABLE
- 2A: UPPER SURFACE
- 2B: LOWER SURFACE
- 3: FIRST GUIDING DEVICE
- 4: SECOND GUIDING DEVICE
- 5: DRIVING SYSTEM
- 31: SLIDER
- 32: RAIL
- 41: SLIDER
- 42: RAIL
- 60: DETECTING SYSTEM
- 61: ENCODER HEAD
- 62: ENCODER HEAD
- 63: LINEAR SCALE
- 100: TABLE DEVICE
- 301: GUIDING MECHANISM
- 302: GUIDING MECHANISM
- 401: GUIDING MECHANISM
- 402: GUIDING MECHANISM
- 500: SEMICONDUCTOR MANUFACTURING DEVICE
- 600: CARRIER DEVICE
- 700: MEASURING DEVICE
- 800: MACHINE TOOL

## Claims

1. A table device comprising:
a first table that includes a first upper surface;
a second table that is arranged on one side of the first table in a first axial direction parallel to a first axis in a predetermined plane and includes a second upper surface;
a first guiding device that guides the first table in the first axial direction; and
a second guiding device that guides the second table in the first axial direction,
wherein the first and second guiding devices are arranged in a second axial direction parallel to a second axis in the predetermined plane, the second axis being perpendicular to the first axis.

2. The table device according to claim 1,
wherein the first guiding device includes a first guiding mechanism that supports one end of the first table in the second axial direction and a second guiding mechanism that supports the other end of the first table,
the second guiding device includes a third guiding mechanism that supports one end of the second table in the second axial direction and a fourth guiding mechanism that supports the other end of the second table, and
the first guiding mechanism is arranged closest to one side in the second axial direction, the third guiding mechanism is arranged, relative to the first guiding mechanism, second closest to the one side, the second guiding mechanism is arranged, relative to the third guiding mechanism, third closest to the one side, and the fourth guiding mechanism is arranged closest to the other side.

3. The table device according to claim 1 or 2, wherein the first and second tables are moved such that an end of one side of the first upper surface and an end of the other side of the second upper surface come close to or come in contact with each other in the first axial direction.

4. The table device according to any one of claims 1 to 3,
wherein the first guiding device includes a first slider connected to a first lower surface of the first table and a first rail along which the first slider moves,
the second guiding device includes a second slider connected to a second lower surface of the second table and a second rail along which the second slider moves,
the first and second rails are arranged in parallel in the second axial direction, and
the first and second sliders are relatively movable in the first axial direction such that at least parts of the first and second sliders are arranged in the second axial direction.

5. The table device according to claim 4, wherein the first and second sliders are separated while at least parts thereof are arranged in the second axial direction.

6. The table device according to claim 4 or 5, wherein, in the first axial direction, a dimension of the first table is smaller than that of the first slider, and a dimension of the second table is smaller than that of the second slider.

7. The table device according to any one of claims 4 to 6, wherein the first and second sliders each include a linear bearing.

8. The table device according to any one of claims 4 to 7 comprising:
a linear scale that is arranged in parallel to the first and second rails;
a first encoder head that is arranged on the first table and capable of detecting the linear scale;
a second encoder head that is arranged on the second table and capable of the linear scale; and
a driving system that moves at least one of the first table and the second table in the first axial direction based on detected values of the first and second encoder heads.

9. A measuring device comprising the table device according to any one of claims 1 to 8.

10. A machine tool comprising the table device according to any one of claims 1 to 8.

11. A semiconductor manufacturing device comprising the table device according to any one of claims 1 to 8.
